# EUROPEAN PATENT APPLICATION

(11) **EP 4 432 789 A1**
(43) Date of publication of application: **18.09.2024**
(21) Application number: 24163659.6
(22) Date of filing: 14.03.2024
(51) Int. Cl.: H05K 1/03, H05K 1/02

(54) **SHEET FOR COMPONENT CARRIER COMPRISING SEPARATE STRUCTURES WITH FILLER PARTICLES HAVING DIFFERENT HOLLOW VOLUME THEREIN**

(30) Priority: 17.03.2023 CN 202310270189
(71) Applicant: AT & S Austria Technologie & Systemtechnik Aktiengesellschaft, 8700 Leoben-Hinterberg (AT)
(72) Inventor: Wang, Nina, Chongqing, 401133 (CN); Baftiri, Artan, Chongqing, 401121 (CN)
(74) Representative: Dilg, Haeusler, Schindelmann Patentanwaltsgesellschaft mbH

(57) **Abstract**

Sheet (100) for manufacturing a component carrier (102), wherein the sheet (100) comprises a first structure (104) comprising first filler particles (108) in a resin matrix (112), and a second structure (106) stacked with the first structure (104) and comprising second filler particles (110) in a resin matrix (112), wherein a hollow volume in a respective one of the second filler particles (110) is larger than in a respective one of the first filler particles (108).

## Description

### Field of the Invention

The invention relates to a sheet, a component carrier, a manufacturing method, and a method of use.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Conventional approaches of forming component carriers are still facing reliability issues. The performance of component carriers manufactured with conventional material cannot meet demanding requirements of certain applications, such as high performance computing, in particular what concerns high-frequency and/or high-speed applications.

### Summary of the Invention

There may be a need to form a mechanically reliable component carrier being appropriate for high-frequency and/or high-speed applications.

According to an exemplary embodiment of the invention, a sheet for manufacturing a component carrier is provided, wherein the sheet comprises a first structure comprising first filler particles in a resin matrix, and a second structure stacked with the first structure and comprising second filler particles in a resin matrix (which may be a further resin matrix or the same resin matrix accommodating the first filler particles), wherein a hollow volume (for example an amount of air) in a respective one of the second filler particles is larger than in a respective one of the first filler particles.

According to another exemplary embodiment of the invention, a component carrier is provided which comprises a stack comprising at least one electrically conductive layer structure and at least one electrically insulating layer structure, wherein the at least one electrically insulating layer structure comprises air filled hollow filler particles having a larger hollow volume (for example a larger amount of air) next to the at least one electrically conductive layer structure than in a surface region of the stack.

According to still another exemplary embodiment of the invention, a manufacturing method is provided which comprises forming a first structure with first filler particles in a resin matrix, forming a second structure with second filler particles in a resin matrix, stacking the first structure with the second structure to thereby form a sheet, and configuring the first filler particles and the second filler particles so that a hollow volume (for example an amount of air) in a respective one of the second filler particles is larger than in a respective one of the first filler particles.

According to still another exemplary embodiment of the invention, component carriers having the above-mentioned features are used for a high-frequency and/or a high speed application. By providing dielectric material with low Dk and/or low Df property, faster speed and/or higher frequency as well as a better signal integrity may be achieved by reducing intensity drops and impedance of electrical transmission. Hence, exemplary embodiments may be in particular applicable for high-frequency applications, in particular for conducting a radio frequency (RF) signal, more particularly a radio frequency signal with a frequency above 1 GHz. It is also possible that exemplary embodiments are applicable for high speed applications such as high speed computing applications. The latter mentioned high speed applications may involve a data rate of at least 1 GB/s, in particular a data rate of at least 5 GB/s.

In the context of the present application, the term "component carrier" may particularly denote any support structure which is capable of accommodating one or more components thereon and/or therein for providing mechanical support and/or electrical and/or thermal connectivity. In other words, a component carrier may be configured as a mechanical and/or electronic and/or thermal carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote a flat or planar body. For instance, the stack may be a layer stack, in particular a laminated layer stack or a laminate. Such a laminate may be formed by connecting a plurality of layer structures by the application of mechanical pressure and/or heat. The stack may comprise at least one electrically conductive layer structure and at least one electrically insulating structure.

In the context of the present application, the term "layer structure" may particularly denote a continuous layer, a patterned layer or a plurality of nonconsecutive islands within a common plane. A layer structure may perform the function of providing electrical conductivity and/or electrical insulation.

In the context of the present application, the term "sheet" may particularly denote a preferably planar structure (such as a foil or film or plate) which may be used as a semifinished product for manufacturing a component carrier. For example, the sheet may comprise or consist of a dielectric material. The sheet may be configured so that it can be laminated with one or more other sheets to form a stack.

In the context of the present application, the term "filler particles" may particularly denote a large plurality of granular structures which may be added to a sheet to provide one or more functions. Such functions may include an improvement of the high-frequency and/or high speed performance by increasing the amount of air or a vacuum volume in an interior of the sheet and an improvement of the mechanical stability of the sheet for manufacturing. However, filler particles may also adjust the thermal conductivity, may enhance the dielectric reliability, may provide a shielding function, etc. For instance, filler particles may have a spherical shape, a cuboid shape, may be beads of arbitrary shape and/or may be shaped as flakes. Other well-defined, ordered, random or arbitrary shapes are possible as well. The filler particles may be made of inorganic material such as SiO₂ or another combined compound of inorganic material (inorganic fillers may be used alone or in combination of two or more kinds at an arbitrary ratio), with which the thermal expansion coefficient of the cured material obtained by curing the resin composition can be reduced and warpage can be controlled. The filler particles can render a depth of a recessed portion of a polishing surface of resin smaller and may reduce the dielectric loss tangent of a cured material obtained by curing the resin composition. Additionally, filler particles may help to reduce the tensile elastic modulus of the cured material. Moreover, the filler particles may be preferably surface-treated with a suitable surface treatment as the surface treatment can suppress an aggregation of the filler particles or a detachment of the filler particles from the polishing surface. They may also contribute to a better uniformity on the resin sheet surface and may improve the moisture resistance and dispersibility of the filler particles.

In the context of the present application, the term "resin matrix" may particularly denote a medium (which may comprise a polymer) in which filler particles may be embedded or accommodated. For instance, such a resin matrix may comprise an epoxy resin. Preferably, the resin matrix may be at least partially uncured before using the sheet for manufacturing a component carrier. Hence, by the application of pressure and/or heat, the at least partially uncured resin matrix may be cured, for instance by triggering cross-linking or polymerization of the resin or part thereof.

In the context of the present application, the term "second structure stacked with first structure" may particularly denote that the first structure and the second structure are arranged on top of each other, in particular connected to each other at facing main surfaces thereof. In other words, the first structure and the second structure may form together a layer stack, for example a double layer stack.

In the context of the present application, the term "hollow volume in filler particles" may particularly denote a void volume, which may contain a gas or a vacuum in a hollow interior of the filler particles. In particular, the hollow volume may contain no liquid and no solid. For example, a partial hollow volume divided by an entire volume of a hollow filler particles may be at least 20%, in particular at least 50%, preferably at least 70%.

In the context of the present application, the term "amount of air in filler particles" may particularly denote a volume or mass of air accommodated in a hollow interior of the filler particles. For example, filler particles having air therein may have one or more interior void volumes. Such filler particles may be hollow filler particles. The air may be hermetically enclosed in an interior of the filler particles. It is however also possible that the filler particles are open towards an environment and have an unfilled gaseous region. For example, a partial air volume divided by an entire volume of a hollow filler particles may be at least 20%, in particular at least 50%, preferably at least 70%.

In the context of the present application, the term "next to at least one electrically conductive layer structure" may particularly denote a location or region of a direct environment of metallic wiring structures of a stack of a component carrier. The spatial neighborship between hollow or air-filled filler particles and electrically conductive layer structure may be to such an extent that the air inside of the filler particles has an impact on the quality of high-frequency signals propagating along the wiring structure.

In the context of the present application, the term "in a surface region of the stack" may particularly denote a region of the stack directly connected to a main surface of the stack. During handling, use and/or assembly of a component carrier, the surface region may be subjected to mechanical stress and/or chemical impact.

In the context of the present application, the term "main surface" of a body may particularly denote one of two largest opposing surfaces of the body or the outermost surfaces of the opposing sides of the body. The main surfaces or outermost surfaces may be connected by circumferential side walls. The thickness of a body, such as a stack, may be defined by the distance between the two opposing main surfaces.

According to a first aspect, a sheet is provided which may be used as a semifinished product for manufacturing a component carrier (such as a printed circuit board, PCB). Such a sheet may be formed as a stack of a first structure with first filler particles in a resin matrix and a second structure with second filler particles in the same or a further resin matrix. Advantageously, a hollow volume or an amount of air in the second filler particles may be larger than a hollow volume or an amount of air in the first filler particles. Air or vacuum in a filler particle may be present in a hollow interior volume of the respective filler particle. When adjusting an inhomogeneous distribution of air or vacuum content in filler particles of a sheet, one side of the sheet with higher air content or larger vacuum volume may be used remote or apart from a surface experiencing mechanical load and chemical impact during processing, whereas the other side of the sheet with lower or no air content or lower or no vacuum volume may withstand such high mechanical load and chemical impact without cracking of filler particles. As a result, breakage of filler particles due to high mechanical load and/or chemical impact may be reliably prevented during a manufacturing process of a component carrier. By the mentioned inhomogeneous distribution of air content or hollow volume of filler particles of the sheet, a high reliability may be obtained. At the same time, the presence of a significant amount of air or hollow volume inside of filler particles being sufficiently remote from high mechanical load and chemical impact may promote high-frequency and high speed performance of an obtained component carrier, since this may lead to a low Dk behaviour. More specifically, a low Dk behaviour may lead to low signal losses and low signal distortion and may decrease the attenuation of signal transmission and ohmic loss and may therefore promote signal integrity. With embodiments of the invention, it may be possible to provide a dielectric material with very low and/or stable Dk and Df value to fulfil demanding requirements for high performance computing, artificial intelligence (AI) applications, and 5G applications ,etc. This may also contribute to a reduction of a mismatch of CTE (coefficient of thermal expansion) between electrically insulating structures and electrically conductive structures by appropriately adjusting the filler particles and resin.

According to a second aspect, a component carrier (such as a PCB) is provided as (preferably laminated) layer stack. The latter may have one or more electrically insulating layer structures having vacuum or air filled hollow filler particles with a larger vacuum volume or amount of air next to an electrically conductive layer structure of the stack than in a surface region of the stack where filler particles may have lower or even no air content or vacuum volume. When a relatively low or even no amount of vacuum or air is present in filler particles in a surface region, the component carrier is robust against filler crashing or cracking in this region, for instance where it is subjected to plating during a manufacturing process. In contrast to this, the vacuum or air amount of filler particles may be higher close to metallic wiring structures of the stack along which electric signals may propagate during operation of the component carrier. When such electric signals are high-frequency and high speed signals (for instance RF, radiofrequency, signals), a low Dk surrounding promoted by the significant air content of the filler particles located in this region may allow propagation of said electric signals with low loss and low signal distortion. Consequently, a component carrier with high mechanical integrity and excellent high-frequency performance may be obtained.

### Detailed Description of Exemplary Embodiments

In the following, further exemplary embodiments of the sheet, the component carrier, and the methods will be explained.

In an embodiment, at least some of the hollow filler particles may have one or more interior vacuum chambers. A vacuum may provide even lower Dk/Df values compared with air. With vacuum inside, the hollow volume amount of hollow filler particles may be larger than their solid volume amount. While the following description explains exemplary embodiments of the invention in particular referring to air-filled hollow filler particles, any other embodiment may use hollow filler particles with at least one interior vacuum chamber.

In an embodiment, the sheet or the component carrier is used for high-frequency applications above 1 GHz, in particular at or above 2 GHz. In particular for such high frequencies and high speed, signal transmission is particularly sensitive to parasitic losses when the dielectric constant is too high. The low Dk and/or Df properties of sheets and component carriers according to exemplary embodiments of the invention allow low loss of signal transmission even with such high-frequency values and dielectric loss tangent.

In an embodiment, the first and/or second filler particles may be functional filler particles providing the respective structure with an assigned technical function. As an example, the filler particles may be configured for reducing the value of the dielectric constant and/or for reducing the CTE mismatch by reducing the tensile elastic modulus of cured dielectric material. The filler particles may be for instance ceramic filler particles, for example comprising silicon oxide, aluminum oxide or aluminum nitride.

Furthermore, a filler content of the filler particles in the respective structure may be for example at least 50 weight percent, in particular ,it may be in a range from 60 weight percent to 80 weight percent, in relation to the overall weight of the respective structure. This may ensure that the function provided by the filler particles has a strong impact on the overall properties of the respective structure.

In different embodiments, there may or may not be a direct physical connection between the first structure and the second structure. There may be the situation that the two structures are stacked with or without an intermediate layer in between. Therefore, the connection between the structures may be direct or indirect. In particular, raw material in a liquid state may vanish during manufacture, then the first structure may be coated, and then the second structure may be coated afterwards. Thus, a direct and an indirect connection of the two stacked structures is possible.

In particular, the resin matrix of at least one of the first structure and the second structure may be at least partially uncured in the sheet so as to be curable by lamination (i.e. the application of heat and/or pressure for connecting different layer structures with each other). For instance, the respective resin matrix may be made of B-stage epoxy resin. A B-stage epoxy resin may denote a chemical system in which a reaction between the resin and a curing agent and/or a hardener is not complete. More generally, an at least partially uncured resin matrix may be in a configuration in which it is still capable of cross-linking or polymerizing. Thus, the respective resin matrix may contribute to the formation of a connection between multiple layer structures of the stack during lamination. The resin matrix of the first structure may be made of the same material as the resin matrix of the second structure, or may be made of another material.

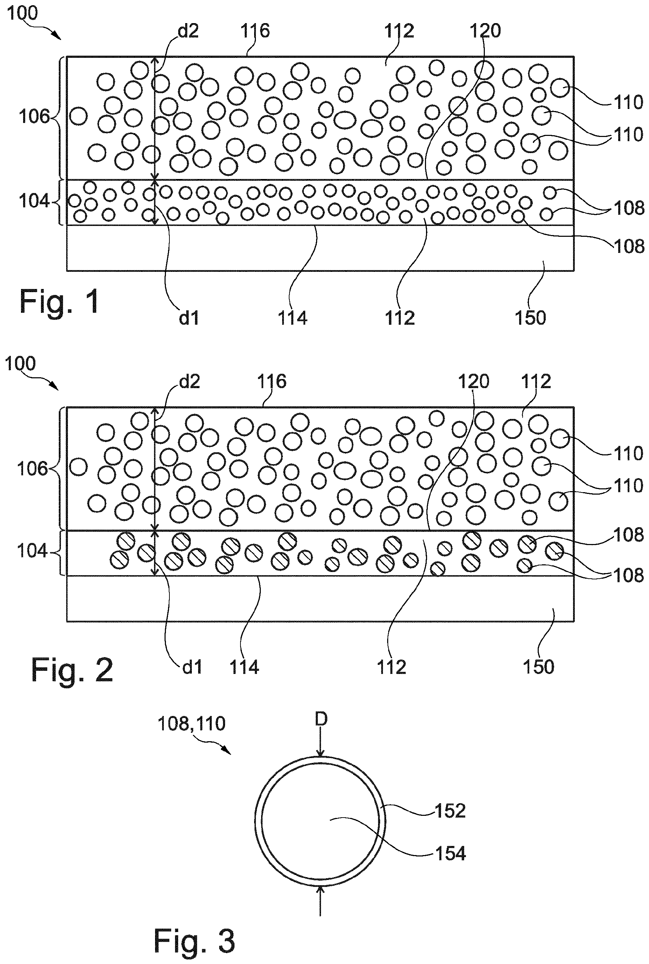

In an embodiment, the first filler particles are solid filler particles and the second filler particles are air filled hollow filler particles. A corresponding embodiment is illustrated in Figure 2. Hence, the first filler particles may be free of a hollow core and may be massive or throughout solid. This may provide excellent protection of the first filler particles against crushing or cracking during manufacturing. Furthermore, this may reduce potential reliability issues when chemicals remain in the dielectric material once the filler particles are damaged . At the same time, the second filler particles may be hollow for providing a low Dk material with advantageous properties in terms of high-frequency and/or high-speed for better signal integrity.

In an embodiment, the solid filler particles of the first structure have a diameter in a range from 0.5 µm to 5 µm. Solid filler particles in the mentioned range of dimensions can be properly processed during a manufacturing process. Such filler particles have sufficient mechanical robustness for withstanding plating and other harsh manufacturing processes without cracking.

However, solid filler particles may also have much smaller diameters, for instance when using nano fillers. Thus, solid fillers may be very small as long as the small size does not impact the mechanical stability of the filler material. Correspondingly, the first structure can be very thin, which may be advantageous for example for fine line structuring.

In an embodiment, the air filled hollow filler particles of the second structure have a diameter in a range from 0.5 µm to 5 µm. Hollow filler particles in this range may allow to provide a sufficiently large air content for effectively reducing the Dk value. Such air filled filler particles may be appropriate for use in the second structure for providing highly appropriate high-frequency properties when being in close spatial vicinity with electrically conductive wiring structures carrying signals during operation of the component carrier.

In another embodiment, the first filler particles are air filled hollow filler particles having a first size and the second filler particles are air filled hollow filler particles having a second size, wherein the second size is larger than the first size. Such an embodiment is shown for example in Figure 1. A corresponding sheet offers excellent properties in terms of high-frequency behavior and ensures low signal losses and high frequency and high speed signal quality. At the same time, the smaller dimensioned hollow filler particles in the first structure are properly protected, in view of their small dimension, against crushing or cracking. It has been found that smaller hollow filler particles are less prone to breakage than larger hollow filler particles. Furthermore, the smaller hollow filler particles also contribute to the low Dk characteristics of the sheet as a whole.

In an embodiment, the air filled hollow filler particles of the first structure have a diameter in a range from 0.1 µm to 1 µm, for instance in a range from 0.1 µm to 0.8 µm. It has turned out that hollow filler particles in the mentioned ranges of diameters can withstand mechanical load occurring during component carrier manufacturing without a significant risk of breakage. At the same time, the air content of such hollow filler particles may provide a contribution to ensure high-frequency signal integrity.

In an embodiment, the air filled hollow filler particles of the second structure have a diameter in a range from 0.5 µm to 5 µm, for instance in a range from 1 µm to 5 µm. When being located sufficiently remote from the surface of the sheet which is processed mechanically and/or chemically during a component carrier manufacturing process, the hollow filler particles have turned out to be less prone to breakage while improving the high-frequency and high-speed properties of the sheet and the component carrier.

In an embodiment, the first structure has a thickness which is smaller than a thickness of the second structure. Already a very thin protection layer in form of the first structure has turned out to be sufficient as a reliable protection against filler particle breakage. When the first structure is thinner than the second structure, a majority of the entire sheet thickness may be used for enhancing the high-frequency and high speed properties by providing hollow filler particles with large air content.

In an embodiment, the first structure has a thickness in a range from 3 µm to 10 µm. Already such a thin first structure may be effective as a protection layer functioning as a robust mechanical buffer for preventing undesired hollow filler particle breakage.

In an embodiment, the second structure has a thickness in a range from 20 µm to 30 µm. Such a second structure offers sufficient space for multiple layers of hollow filler particles for efficiently enhancing signal quality in particular for high-frequency and high speed applications.

In an embodiment, hollow filler particles of the first structure and/or of the second structure may have a shell enclosing a hollow volume. Preferably, a ratio between a thickness of the shell and an exterior diameter of the shell and therefore of the filler particle may be in a range from 0.01 to 0.2, for example in a range from 0.05 to 0.1. In the context of the present application, the diameter of a filler particle may be its largest dimension. Correspondingly, the thickness of the shell may be its maximum thickness.

In an embodiment, an exposed main surface of the first structure is configured for exposure to chemical and/or mechanical processing, for example for plating. In the context of the present application, the term "configured for exposure to chemical and/or mechanical processing" may particularly denote that the first structure can withstand mechanical load and chemical agents which may act on an exposed sheet surface during manufacturing a component carrier. In particular, the first structure may be capable of withstanding an impact of laminating processes, plating processes, etching processes, plasma processes, mechanical and/or laser drilling processes, and/or chemical mechanical polishing without breakage of the first filler particles.

In an embodiment, an exposed main surface of the second structure is configured for being laminated on a base structure. In the context of the present application, the term "configured for being laminated on a base structure" may particularly denote a capability of the second structure to be connected with a base structure (such as a core, a layer build-up or an already laminated layer stack) by lamination, i.e. the application of heat and/or pressure. This may also include the capability of the resin matrix of the second structure to be curable by thermal energy and/or mechanical pressure, i.e. an at least partially uncured property of the resin matrix prior to lamination. When exposing the exposed main surface of the second structure to a plating process, hollow second filler particles at the main surface of the second structure might break.

In an embodiment, the sheet comprises an interface plane between the first structure and the second structure separating the first filler particles from the second filler particles. In one alternative, the interface plane may be a mere connection plane between a connection surface of the first structure and a connection surface of the second structure. In such a scenario, the first structure and the second structure may form a double layer. In another alternative, the interface plane may be specifically configured as a barrier suppressing or eliminating migration of material (in particular of filler particles) between the first structure and the second structure. In particular, it may then be possible that the interface plane is formed by a third structure (such as a barrier layer or an interface layer) which may be configured for refining the properties of the sheet as a whole. Such an intermediate third structure may or may not comprise hollow and/or solid filler particles.

In an embodiment, the sheet comprises an intermingling region (or mixing region) between the first structure and the second structure in which first filler particles and second filler particles are intermingled (or mixed). Such an intermingling region may form a smooth transition between the first filler particles of the first structure and the second filler particles of the second structure. Alternatively, an abrupt transition from the first filler particles to the second filler particles may be formed.

In an embodiment, an overall hollow volume (which may be a vacuum volume or a volume filled with gas only) in the second filler particles is larger than an overall hollow volume in the first filler particles. For example, an overall air volume in the second filler particles is larger than an overall air volume in the first filler particles. The overall vacuum or air volume of the second filler particles may be larger than zero and may be the sum of the individual vacuum or air volumes of all second filler particles of the second structure. Correspondingly, the overall vacuum or air volume of the first filler particles may be zero or larger than zero and may be the sum of the individual zero or non-zero vacuum or air volumes of all first filler particles of the first structure. When the overall vacuum or air volume of the second filler particles is larger than the overall vacuum or air volume of the first filler particles, a high mechanical robustness of the first structure may be combined with a low Dk property of the second structure.

In an embodiment, the first structure is a first layer and/or the second structure is a second layer. Hence, the first structure may be a planar structure and/or the second structure may be a planar structure. In particular, the first structure may be connected with the second structure at planar connection surfaces thereof to form a double layer.

However, it may be possible in another embodiment that the first structure and/or second structure is not planar, for example has a curved and/or stepped surface profile. In particular, it may be possible to form connection surfaces of the first structure and/or the second structure with pronounced roughness, which may be evened when laminating the first structure and the second structure together as one whole sheet. Although a planar surface of the whole sheet may be desired, connection portions of the first and second structures can be planar or non-planar. However, if the two structures are not planar or one of the structures is not planar, the second structure's thickness variation may be increased to ensure a planarity of the whole sheet (for example if the first structure's thickness shall be as thin as possible).

In an embodiment, the first structure is directly connected with the second structure. Hence, there may be a direct physical connection between first structure and second structure without an intermediate structure in between. This may ensure a compact design of the sheet. Alternatively, at least one additional structure may be in between the first structure and the second structure. Such an additional intermediate structure may be a barrier preventing material migration between first and second structure and/or may be an adaptation layer providing a smooth or continuous transition between the properties of the first and second structures.

For instance, the first filler particles of the first structure may all be made of the same material, for example glass. Alternatively, different subgroups of the first filler particles may be made of different materials, for instance glass and aluminum nitride. Furthermore, the first filler particles may all have the same size. However, a person skilled in the art will be aware of the fact that, due to manufacturing tolerances, first filler particles of the same size may have slightly different dimensions. Alternatively, the first filler particles may have a size distribution (for instance may have a distribution of dimensions in accordance with the above mentioned ranges for the first filler particles). It is also possible that all first filler particles are throughout solid (or non-hollow or without macroscopic interior voids) or are all hollow. Alternatively, the first filler particles may be partially throughout solid and partially hollow.

For instance, the second filler particles of the second structure may all be made of the same material, for example glass. Alternatively, different subgroups of the second filler particles may be made of different materials, for instance glass and aluminum nitride. Furthermore, the second filler particles may all have the same size. However, a person skilled in the art will be aware of the fact that, due to manufacturing tolerances, second filler particles of the same size may have slightly different dimensions. Alternatively, the second filler particles may have a size distribution (for instance may have a distribution of dimensions in accordance with the above mentioned ranges for the second filler particles). It is also possible that all second filler particles are hollow. Alternatively, the second filler particles may be partially throughout solid and partially hollow.

In an embodiment, an amount of air in a respective one of first filler particles in the surface region of the stack is smaller than in a respective one of second filler particles next to the at least one electrically conductive layer structure. Correspondingly, an amount of air in a respective one of first filler particles in the first structure is smaller than an amount of air in a respective one of second filler particles in the second structure. Thus, second filler particles directly surrounding the electrically conductive layer structure(s), which may function as electric wiring structure(s) during operation of the component carrier, may provide a higher amount of air volume than first filler particles at a stack surface. This may allow processing of the stack surface even under harsh conditions without the risk of breakage of filler particles while an interior of the stack may enhance low DK properties.

In an embodiment, the surface of the stack is free of broken hollow filler particles. In this context, broken hollow filler particles are those having a damaged shell so that a hollow interior of the broken hollow filler particles does not provide a defined volume that may not be filled by surrounding material. Such broken hollow filler particles, which may lead to reliability issues of the component carrier, may be avoided by the above-described configuration of the first filler particles.

In an embodiment, the at least one electrically insulating layer structure of the component carrier comprises a sheet having the above mentioned features. Correspondingly, the method may comprise manufacturing a component carrier by forming a stack comprising at least one electrically conductive layer structure and at least one electrically insulating layer structure, wherein the at least one electrically insulating layer structure is formed based on such a sheet. For example, the stack may be composed of one or more electrically conductive layer structures (such as patterned metal layers and/or plated metallic vias) and one or more electrically insulating layer structures at least a part of which being formed by a sheet with the above properties. After lamination of the layer structures, resin material of the respective sheet may be converted from an initially partially uncured configuration into a cured configuration (with cross-linked or polymerized resin, in particular epoxy resin).

In an embodiment, the method comprises forming a layer comprising the first structure with the first filler particles on one side of the layer and comprising the second structure with the second filler particles on an opposing other side of the layer. In one embodiment, one side of the layer may be provided with larger spheres, whereas the other side of the layer may be provided with smaller spheres.

In an embodiment, the smaller spheres and the larger spheres may be mixed together with random distribution in a portion, in particular in a central portion, of the same layer. When hollow fillers and solid fillers are in the same layer, there are in particular the following two options: In one option or alternative, there is only one layer. In another option or alternative, there are still two layers, for instance a top layer with hollow fillers and solid fillers, and a bottom layer with only solid fillers. Preferably, the amount of hollow filler particles is larger than the amount of solid filler particles. However, the size of solid filler particles may be larger than the size of hollow filler particles. Therefore, the pressure on the surface may be more sustained by the solid filler particles, and the hollow filler particles may be better protected against breakage. This may result in a good mechanical stability and a low Dk/Df of the material.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FRS, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component being surface mounted on and/or embedded in the stack of the component carrier can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a sheet for a component carrier according to an exemplary embodiment of the invention.
Figure 2 illustrates a cross-sectional view of a sheet for a component carrier according to another exemplary embodiment of the invention.
Figure 3 illustrates a cross-sectional view of a hollow particle of a sheet for a component carrier according to an exemplary embodiment of the invention.
Figure 4 and Figure 5 illustrate diagrams demonstrating effects of sheets according to an exemplary embodiment of the invention.
Figure 6 illustrates a cross-sectional view of a component carrier according to an exemplary embodiment of the invention.
Figure 7 illustrates a cross-sectional view of a component carrier according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Due to better performance requirements in terms of dielectric material, materials may be used which comprise hollow filler particles in order to decrease the DK value. In conventional approaches, hollow filler particles may be distributed homogeneously throughout a dielectric material. However, hollow filler particles may be broken when subjected to high mechanical impact. This may lead in particular to cracked filler particles in a surface region. This may, in turn, deteriorate the function of the filler particles and may have a negative impact on reliability and performance of the component carrier.

According to an embodiment of the invention related to a first aspect, a semifinished product in form of a sheet may be used as a constituent of a (preferably laminated) layer stack of a component carrier (for example an IC substrate or a PCB). A corresponding sheet may comprise a first structure having first filler particles distributed in a resin matrix stacked with a second structure having second filler particles distributed in a resin matrix (which may be made of the same or another resin as the aforementioned resin matrix). An overall amount of air in an interior of the second filler particles can be selected to be larger than an overall amount of air in an interior of the first filler particles. The amount of air inside the second filler particles is larger than zero, whereas the amount of air inside the first filler particles may be zero or larger than zero but smaller than the amount of air inside the second filler particles. Hence, the first filler particles may be mechanically more robust than the second filler particles and may thus be less prone to cracking or crushing. At the same time, the second filler particles may have a pronounced low Dk characteristic and may thus be better suited for high-frequency and/or high-speed applications than the first filler particles. Accordingly, the first filler particles are appropriate for being arranged close to a surface being subjected to high forces and/or aggressive chemicals during a manufacturing process, whereas the second filler particles are specifically configured for being placed in spatial vicinity with electric wiring structures guiding or carrying high-frequency and/or high-speed signals during operation of the component carrier. As a result of the described configuration of the sheet, breakage of first filler particles close to a surface processed during a manufacturing process of a component carrier may be prevented. Simultaneously, the significant air content inside of the second filler particles may enhance compatibility with high-frequency requirements of a component carrier in view of the provided low DK attributes.

According to a second aspect, a component carrier is provided which may be manufactured using one or more of the above mentioned sheets. Electrically insulating layer structures of such a component carrier may comprise air containing filler particles with a significant amount of air spatially close to an electrically conductive layer structure of a layer stack carrying high-frequency and/or high-speed signals during operation of the component carrier. In contrast to this, a smaller amount of air or even no air may be present in filler particles at a surface of the stack. Thus, crushing or cracking of filler particles at or close to the surface may be prevented even in the event of mechanical load or a chemical attack, so that a component carrier with high structural integrity may be manufactured. As a result, a component carrier may be provided which has both pronounced low Dk attributes and a high mechanical reliability.

According to an exemplary embodiment of the invention, a dielectric material may be provided that may ensure a reliable performance for a final component carrier-related application by distributing filler particles, at least part of which being hollow, inhomogeneously within a sheet or layer structure.

According to an exemplary embodiment of the invention, the dielectric material is segmented into a first part of the material with larger filler dimension that includes the risk of having cracked fillers (which may however be acceptable in this region) but keeps the dielectric constant low, and a second part of the material that may be exposed to a dielectric surface where fillers will not be hollow. A total thickness of the latter part can be in a range from 1 µm to 8 µm.

According to another exemplary embodiment of the invention, a first part of the material with larger filler distribution may include the risk of having cracked fillers (which may however be acceptable in this region) but keeps the dielectric constant low, and a second part of the material will be exposed to a dielectric surface where the hollow filler size may be reduced. For instance, the reduction of the filler thickness may be to less than 0.8 µm. For example, a total thickness of this part can be in a range from 1 µm to 8 µm. Crack risk reduction is a function of filler size, and smaller filler sizes lead to a higher resistance to crush.

Advantageously, a selectively inhomogeneous and well-defined distribution of filler particles, at least part of which being hollow, may allow to use dielectric material with low Dk value highly efficiently for component carrier applications. To put it shortly, segmentation may be applied to the characteristic of the filler particles in order to offer mechanical strength where needed. Highly advantageously, this may reduce or even eliminate the risk of cracked fillers exposed on a dielectric material surface during a component carrier manufacturing process.

Advantageously, the implemented filler particles may be made of glass. A low-DK PCB material has a low dielectric constant (more specifically real part). The term DK refers specifically to the real part of the dielectric constant (i.e. the refractive index).

Exemplary applications of exemplary embodiments of the invention are printed circuit board (PCBs) and integrated circuit (IC) substrates providing an electronic application where high-frequency and/or high-speed processing and good signal integrity are required. Exemplary embodiments of the invention may be component carriers demanding high frequency transmission, such as CPU (central processing unit) and/or GPU (graphical processing unit) for servers and/or other high performance computing application like AI (artificial intelligence), or Field Programmable Gate Arrays (FPGAs).

Descriptively speaking, exemplary embodiments may specifically distribute hollow filler particles to solve reliability issues caused by crushed hollow fillers in certain regions of a sheet or a component carrier. Advantageously, this may lead to a mitigation of reliability risks. At the same time, the inhomogeneous distribution of filler particles may have some impact on the DK behavior while strongly suppressing crushing of hollow fillers. More specifically, exemplary embodiments of the invention may spatially segment a hollow filler distribution to increase the reliability of low DK dielectrics of or for a component carrier.

Exemplary embodiments may improve the dielectric properties of PCB materials by filling them with hollow particles. The particle dimensions (in particular average particle size, surface area) may influence the dielectric constant, the dielectric loss and the mechanical strength of the filled materials. An exemplary embodiment may provide a sheet as dielectric coating layer having a two-layer structure. Each layer (or more generally structure) may contain hollow particles, but in different concentrations and/or with different dimensions. Thus, a dielectric sheet or layer may be provided which contains hollow particles of different types. In particular, it may be possible to combine a first structure or layer containing first hollow fillers having a first particle diameter with a second structure or layer containing second fillers having a second particle diameter.

In particular, it may be advantageous to reduce diameter size of the hollow fillers on the side of the sheet (in particular configured as build-up film) that will be plated upon in further processing during manufacture of component carriers. However, it may also be possible to substitute hollow fillers in one of the layers or structures with non-hollow or throughout solid fillers on the other layer or structure that will be exposed to plating during further processing. Hence, the sheet may be configured to obtain a reliable build-up film supporting high-frequency and/or high-speed applications and being reliably protected against crushing of hollow fillers.

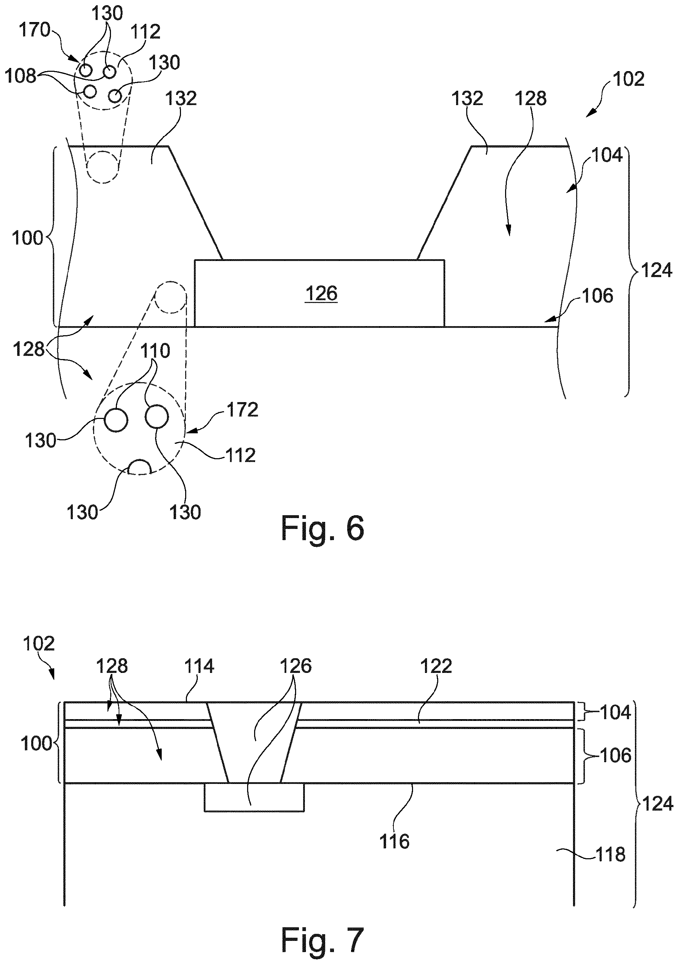

**Figure 1** illustrates a cross-sectional view of a planar sheet 100 as a constituent for manufacturing a component carrier 102, such as the one shown in Figure 6 or Figure 7, according to an exemplary embodiment of the invention. Sheet 100 can be used as a laminate layer for forming a layer stack 124 together with other electrically conductive layer structures and/or electrically insulating layer structures. Thus, sheet 100 of Figure 1 may be used as a dielectric for manufacturing a component carrier 102 which may be embodied as a printed circuit board (PCB) or integrated circuit (IC) substrate.

Sheet 100 for manufacturing component carrier 102 may be formed on a support layer 150, which may be for example a carrier layer of Polyethylene terephthalate (PET). Support layer 150 may or may not form part of sheet 100 and may also be omitted. The sheet 100 comprises a first structure 104 and a second structure 106 directly thereon. The first structure 104 may be formed directly on the support layer 150. The second structure 106 may be formed directly on the first structure 104.

The first structure 104, which is shaped as a planar layer in the shown embodiment, comprises first filler particles 108 in a resin matrix 112.

Preferably, the resin matrix 112 of the first structure 104 is in an at least partially uncured condition, for instance is embodied as B-stage epoxy resin. Resin in an at least partially uncured condition may be capable of being cured upon supply of heat and/or upon exertion of mechanical pressure so that cross-linking and/or polymerizing reactions of the resin may be triggered which may lead to curing. By configuring the resin matrix 112 of the first structure 104 to comprise an at least partially uncured resin (and optionally one or more further additives), first structure 104 may be laminated onto a destination structure, such as a layer stack.

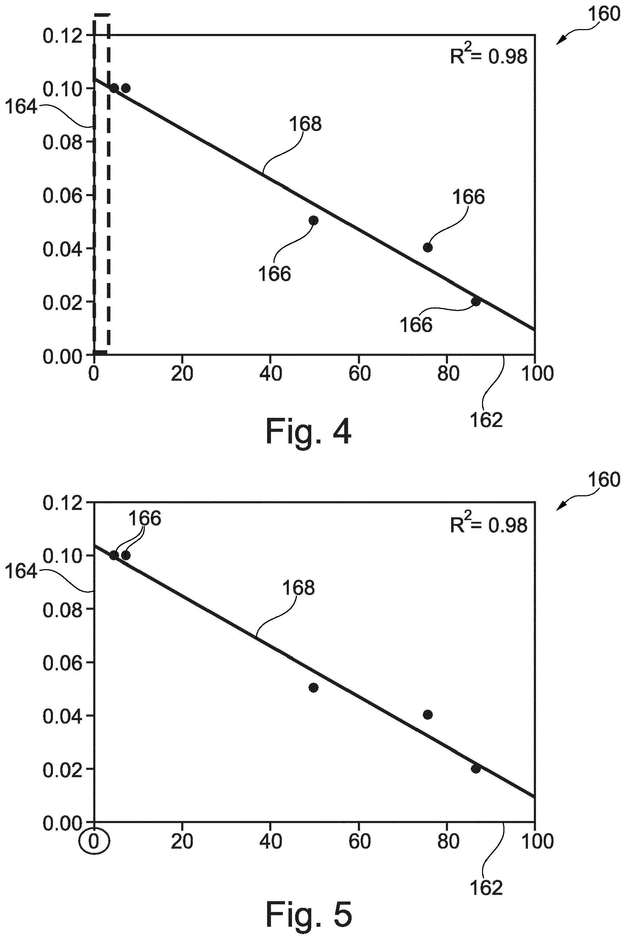

Still referring to Figure 1, all first filler particles 108 of the first structure 104 are air filled hollow filler particles having a first size. More specifically and now referring to Figure 3, each of the first filler particles 108 may have a circumferentially closed shell 152, which may have for example a spherical shape. Inside of the circumferentially closed shell 152, an air-filled hollow volume 154 is delimited. Preferably, the air filled hollow first filler particles 108 of the first structure 104 have a very small diameter D in a range from 0.1 µm to 1 µm. This small dimension strongly suppresses any tendency of breakage of the hollow first filler particles 108 when exerting mechanical pressure or load thereon, and also in the presence of aggressive chemicals. This phenomenon will be explained below in further detail referring to Figure 4 and Figure 5. By being hollow, first filler particles 108 additionally contribute to a low DK behavior of sheet 100, since the air of the hollow volume 154 has a very small dielectric constant.

Since the described configuration of the first filler particles 108 renders them robust against mechanical load and chemical impact, an exposed main surface 114 of the first structure 104 (after removing the sheet 100 from the support layer 150) can be exposed to chemical and/or mechanical processing, for instance to plating, without excessive risk of damage. During a component carrier manufacturing process, main surface 114 may be the side of the sheet 100 which will be exposed for example to a desmear process when building metallic structures thereon. Hence, main surface 114 may be subjected to mechanical and chemical processing and is thus the side of the sheet 100 which is more prone to breakage of its first filler particles 108. By configuring them hollow, but with a small diameter D, they may be properly protected against breakage.

The second structure 106, which is vertically stacked and arranged in parallel with the first structure 104, is also shaped as a layer and comprises second filler particles 110 in a further resin matrix 112.

Preferably, the further resin matrix 112 of the second structure 106 is in an at least partially uncured condition, for instance is embodied as B-stage epoxy resin. By configuring the further resin matrix 112 of the second structure 106 to comprise an at least partially uncured resin (and optionally one or more further additives), second structure 106 may be laminated onto a destination structure, such as a layer stack.

Referring to Figure 1 and Figure 3, also all second filler particles 110 of the second structure 106 are air filled hollow filler particles. However, the second filler particles 110 have a second size which is larger than the first size of the first filler particles 108. Preferably, the air filled hollow filler particles of the second structure 106 have a diameter D in a range from 0.5 µm to 5 µm. The diameter D of all second filler particles 110 may be larger than the diameter D of all first filler particles 108. Still referring to Figure 3, each of the second filler particles 110 may have a circumferentially closed shell 152, which may have for example a spherical shape. Inside of the circumferentially closed shell 152, an air-filled hollow volume 154 is delimited. By this configuration of the second filler particles 110, a considerable amount of air is added to sheet 100. Thus, second structure 106 strongly contributes to the configuration of sheet 100 as low Dk dielectric. Consequently, sheet 100 is highly appropriate for high-frequency and/or high-speed applications, since the low DK characteristic in particular of the second structure 106 leads to low signal losses and high signal transmission quality. Since an exposed main surface 116 of the second structure 106 is configured for being laminated on a base structure (see for example reference design 118 in Figure 7), main surface 116 will not be exerted to excessively harsh conditions as main surface 114, so that there is no excessive risk of breakage of the second filler particles 110 during manufacture of a component carrier 102 based on sheet 100. Moreover, potential breakage of second filler particles 110 may be less critical than potential breakage of first filler particles 108. To put it shortly, main surface 116 of sheet 100 can be used during a subsequent component carrier manufacturing process for lamination on a base structure or carrier and is therefore less prone to breakage despite of its more resilient properties.

As a consequence of the described geometry of the first filler particles 108 and the second filler particles 110 of sheet 100 of Figure 1, an amount of air in a respective one of the second filler particles 110 is larger than in a respective one of the first filler particles 108. Furthermore, an overall air volume of all second filler particles 110 together is larger than an overall air volume of all first filler particles 108 together.

Furthermore, the first structure 104 has a thickness d1 which is smaller than a thickness d2 of the second structure 106. For instance, the first structure 104 has a thickness d1 in a range from 3 µm to 10 µm, for example 5 µm. Advantageously, the second structure 106 may have a thickness d2 in a range from 20 µm to 30 µm, for instance 25 µm. Thus, a major portion of the sheet 100 may be adapted for adjusting a low DK behavior, whereas only a minor portion of the sheet 100 may be configured for avoiding breakage of hollow filler particles close to a surface of sheet 100 being processed under harsh conditions during manufacture of a component carrier 102.

As shown as well in Figure 1, sheet 100 comprises an interface plane 120 between the first structure 104 and the second structure 106 which separates the first filler particles 108 from the second filler particles 110. Interface plane 120 may function as a barrier for keeping the functions of the first structure 104 and the second structure 106, which are closely correlated with the properties of the first filler particles 108 and the second filler particles 110, respectively, separate from each other. It may also be possible that there is no interface between the two layers, for example if they are mixed with each other.

Sheet 100 according to Figure 1 may be realized with film segmentation and has refined properties concerning mechanical robustness and high-frequency compatibility. For manufacturing sheet 100 according to Figure 1, it may be possible to first coat a film with hollow fillers of limited size (for example having a diameter D of preferably less than 0.6 µm diameter), preferably not larger than 3 µm to 5 µm. Sheet 100 may be finalized by coating with larger hollow fillers. As a result, sheet 100 with low DK properties and increased crack resistance may be obtained.

**Figure 2** illustrates a cross-sectional view of a sheet 100 for a component carrier 102 according to another exemplary embodiment of the invention.

The embodiment of Figure 2 differs from the embodiment of Figure 1 in particular in that, according to Figure 2, the first filler particles 108 are massive or throughout solid filler particles, while the second filler particles 110 are air filled hollow filler particles. The solid first filler particles 108 of the first structure 104 may be made of glass and may have a diameter D in a range from 0.5 µm to 5 µm. Also the air filled hollow second filler particles 110 of the second structure 106 may have a diameter D in a range from 0.5 µm to 5 µm. When massive or throughout solid fillers are used for the first filler particles 108 facing main surface 114 which may be subjected to harsh metallization processes during component carrier manufacture the filler dimensions may be larger than in the embodiment of Figure 1 without running the risk of breakage of fillers and therefore damage of a component carrier 102. At the same time, the hollow second filler particles 110 may ensure a high air content in sheet 100 and consequently a low DK behaviour.

Sheet 100 according to Figure 2 may be realized with film segmentation and substitutes filler particles to obtain both mechanical robustness and high-frequency compatibility. For manufacturing sheet 100 according to Figure 2, it may be possible to first coat a film with non-hollow fillers, preferably in a range from 3 µm to 5 µm. Sheet 100 may be finalized by coating with hollow fillers. As a result, sheet 100 with low DK properties and high mechanical resistance may be obtained.

**Figure 3** illustrates a cross-sectional view of a hollow particle 108/110 of a sheet 100 for a component carrier 102 according to an exemplary embodiment of the invention. More specifically, the hollow first filler particles 108 of sheet 100 of Figure 1 and the hollow second filler particles 110 of sheet 100 according to Figure 1 or Figure 2 may be constructed as shown in Figure 3. Generally, the air filled hollow filler particles may have a diameter D in a range from 0.1 µm to 5 µm, wherein preferred sub-ranges may be selected as described above referring to Figure 1 and Figure 2.

Filler particles 108/110 may be randomly distributed within the respective resin matrix 112. Depending on the filler size and the position of filler particles within a sheet 100, the risk of cracks on the surface for hollow fillers may vary, as will be explained below referring to Figure 4 and Figure 5. For example for a filler size in a range from above 0.5 µm to 5 µm, hollow fillers may be prone to breakage when arranged within first structure 104 which may face high mechanical load and/or aggressive chemicals at its main surface 114 during a component carrier manufacturing process.

**Figure 4** and **Figure 5** illustrate diagrams 160 demonstrating effects of sheets 100 according to an exemplary embodiment of the invention. Each of the diagrams 160 of Figure 4 and Figure 5 has an abscissa 162 along with a percentage of broken filler particles (which may also be denoted as broken microspheres rate) is plotted. Along an ordinate 164, a ratio between thickness and diameter of hollow filler particles is plotted. In this context, thickness relates to the wall thickness of shell 152, whereas diameter relates to diameter D of Figure 3. Several measurement points 166 are shown based on which a linear regression curve 168 is derived. To put it shortly, large and thin-shelled hollow filler particles are more prone to breakage than small and thick-shelled hollow filler particles. This finding allows to properly design diameter, wall thickness and air filling degree of filler particles 108, 110 used for constructing a sheet 100 according to an exemplary embodiment of the invention.

Concluding, Figure 4 and Figure 5 illustrate the impact of the size of hollow fillers to filler crash. When hollow fillers are thin-shelled, they may be broken by applied compression or shear force. As shown, the ratio thickness/diameter is a key characteristics of the microsphere that defines the resistance to crash and consequently the percentage of the broken spheres observed. Reducing the size of the fillers may increase the thickness/diameter ratio. In diagram 160, it is possible to observe the clear tendency of creating broken fillers. As shown in Figure 4, the mentioned ratio defines the resistance to crash (i.e. the percentage of the broken spheres).

Referring to the embodiment of Figure 1, crack on fillers can be accepted in second structure 106 so as to benefit from the electrical properties of a larger filler size (i.e. more air volume). Hence, a diameter D of hollow second filler particles 110 can be in a range from 0.1 µm to 5 µm. However, cracks of a significant portion of fillers cannot be accepted in first structure 104, because this side of sheet 100 may be later on plated with electroless copper, causing the risk for copper migration and copper residues during the manufacturing process. This phenomena may be hard to eliminate once plated inside hollow fillers. Hence, a diameter D of hollow first filler particles 108 can be in the range from 0.1 µm to 1 µm.

Now referring to the embodiment of Figure 2, crack on fillers can be accepted in second structure 106 so as to benefit from the electrical properties of a larger filler size (i.e. more air volume). Hence, a diameter D of hollow second filler particles 110 can be in the range from 0.1 µm to 5 µm. However, cracks of a significant portion of fillers cannot be accepted in first structure 104. According to Figure 2, the risk of broken fillers in first structure 104 is completely eliminated no matter what the filler size is, since the first filler particles 108 are massive or throughout solid according to Figure 2. For example, an acceptable range of filler sizes may be from 0.1 µm to 5 µm. An additional advantage of this embodiment is an adjusted thermal conductivity in plane thanks to the solid first filler particles 108 which may overcome limits concerning heat dispersion.

**Figure 6** illustrates a cross-sectional view of a component carrier 102 according to an exemplary embodiment of the invention. For instance, component carrier 102 may be a printed circuit board (PCB) or an integrated circuit (IC) substrate. More precisely, Figure 6 only illustrates an upper portion of the component carrier 102.

As illustrated, component carrier 102 comprises a laminated layer stack 124 comprising a plurality of electrically conductive layer structures 126 (only one of which being shown in Figure 6) and a plurality of stacked electrically insulating layer structures 128. For example, the uppermost electrically insulating layer structure 128 may be configured as sheet 100 according to an exemplary embodiment of the invention, for instance as described above referring to Figure 1. A detail 170 shows a portion of first structure 104, whereas a detail 172 illustrates a section of second structure 106.

As shown, the uppermost electrically insulating layer structure 128 comprises air filled hollow filler particles 130 having a larger amount of air next to the illustrated electrically conductive layer structure 126 (corresponding to the above-mentioned second filler particles 110 of second structure 106) than in a surface region 132 of the stack 124 (corresponding to the above-mentioned first filler particles 108 of first structure 104). Accordingly, an amount of air in a respective one of first filler particles 108 in the surface region 132 of the stack 124 is smaller than in a respective one of second filler particles 110 next to the electrically conductive layer structure 126. As shown, the surface of the stack 124 is free of broken hollow filler particles.

This construction has advantages: The smaller hollow filler particles 130 in the surface region 132 are located at a side of sheet 100 at which a metallizing plating process attacks the exterior surface with mechanical load and chemical impact. Here, the hollow filler particles 130 shall be properly protected from breaking, since this might reduce the quality of the metallization. At the same time, the larger hollow filler particles 130 directly next to the electrically conductive layer structure 126 (configured as electric wiring structure carrying electric signals during operation of component carrier 100) and deeper inside stack 124 ensure a low DK characteristic close to the electric signals. Consequently, such electric signals - in particular when being high-frequency signals or high-speed signals - will not suffer significant distortion or attenuation. As a result, a high signal integrity may be obtained.

**Figure 7** illustrates a cross-sectional view of a component carrier 102 (such as a PCB or an IC substrate) according to another exemplary embodiment of the invention.

As shown, the component carrier 102 may comprise a laminated layer stack 124 comprising a plurality of electrically conductive layer structures 126 and of electrically insulating layer structures 128. The electrically conductive layer structures 126 may comprise patterned copper layers which may form horizontal pads and/or a horizontal wiring structure. Additionally or alternatively, the electrically conductive layer structures 126 may comprise vertical through connections such as copper pillars and/or copper filled laser vias. Moreover, the stack 124 of the component carrier 102 may comprise one or more electrically insulating layer structures 128, such as prepreg or resin sheets. One or more electrically insulating layer structures 128 may be configured as a sheet 100 according to an exemplary embodiment of the invention, compare for instance the embodiments of Figure 1 and Figure 2. Also surface finish (like ENIG or ENEPIG, a solder resist, etc.) may be optionally applied on the top side and/or on the bottom side of the stack 124 (not shown).

As shown, sheet 100 is formed on top of a base structure 118, such as a fully cured core or a laminated layer build-up or patterned layer stack. According to Figure 7, sheet 100 is composed of three stacked layers, i.e. a top sided first structure 104, a bottom sided second structure 106 and an intermingling region 122 between the first structure 104 and the second structure 106. The first structure 104 and the second structure 106 can be constructed, for example, as described above referring to Figure 1 or Figure 2. In the intermingling region 122 (which may also be denoted as mixing region), first filler particles 108 of the first structure 104 and second filler particles 110 of the second structure 106 are intermingled or mixed. Moreover, the intermingling region 122 may comprise material from the resin matrix 112 of the first structure 104 and/or of the second structure 106. To put it shortly, the intermingling section 122 may create a homogeneous transition between the first structure 104 and the second structure 106 and may thereby avoid an abrupt change of the properties of sheet 100.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A sheet (100) for manufacturing a component carrier (102), wherein the sheet (100) comprises:
a first structure (104) comprising first filler particles (108) in a resin matrix (112); and
a second structure (106) stacked with the first structure (104) and comprising second filler particles (110) in a resin matrix (112);
wherein a hollow volume in a respective one of the second filler particles (110) is larger than in a respective one of the first filler particles (108).

2. The sheet (100) according to claim 1, wherein an amount of air in a respective one of the second filler particles (110) is larger than in a respective one of the first filler particles (108).

3. The sheet (100) according to claim 1 or 2, wherein the first filler particles (108) are solid filler particles and the second filler particles (110) are air filled hollow filler particles.

4. The sheet (100) according to claim 3,
wherein the solid filler particles of the first structure (104) have a diameter (D) in a range from 0.5 µm to 5 µm; and/or
wherein the air filled hollow filler particles of the second structure (106) have a diameter (D) in a range from 0.5 µm to 5 µm.

5. The sheet (100) according to claim 1 or 2, wherein the first filler particles (108) are air filled hollow filler particles having a first size and the second filler particles (110) are air filled hollow filler particles having a second size, wherein the second size is larger than the first size.

6. The sheet (100) according to claim 5,
wherein the air filled hollow filler particles of the first structure (104) have a diameter (D) in a range from 0.1 µm to 1 µm; and/or
wherein the air filled hollow filler particles of the second structure (106) have a diameter (D) in a range from 0.5 µm to 5 µm.

7. The sheet (100) according to any of claims 1 to 6, wherein at least one of the following features applies:
wherein the first structure (104) has a thickness (d1) which is smaller than a thickness (d2) of the second structure (106);
wherein the first structure (104) has a thickness (d1) in a range from 3 µm to 10 µm;
wherein the second structure (106) has a thickness (d2) in a range from 20 µm to 30 µm;
wherein an exposed main surface (114) of the first structure (104) is configured for exposure to chemical and/or mechanical processing, for example for plating;
wherein an exposed main surface (116) of the second structure (106) is configured for being laminated on a base structure (118).

8. The sheet (100) according to any of claims 1 to 7, comprising:
an interface plane (120) between the first structure (104) and the second structure (106) separating the first filler particles (108) from the second filler particles (110); or
an intermingling region (122) between the first structure (104) and the second structure (106) in which first filler particles (108) and second filler particles (110) are intermingled.

9. The sheet (100) according to any of claims 1 to 8, wherein at least one of the following features applies:
wherein an overall hollow volume in the second filler particles (110) is larger than an overall hollow volume in the first filler particles (108);
wherein an overall air volume in the second filler particles (110) is larger than an overall air volume in the first filler particles (108);
wherein the first structure (104) is a first layer and/or the second structure (106) is a second layer;
wherein the first structure (104) is directly connected with the second structure (106).

10. A component carrier (102), which comprises:
a stack (124) comprising at least one electrically conductive layer structure (126) and at least one electrically insulating layer structure (128);
wherein the at least one electrically insulating layer structure (128) comprises hollow filler particles (130) having a larger hollow volume next to the at least one electrically conductive layer structure (126) than in a surface region (132) of the stack (124).

11. The component carrier (102) according to claim 10,
wherein the hollow filler particles (130) are air filled hollow filler particles (130) having a larger amount of air next to the at least one electrically conductive layer structure (126) than in the surface region (132) of the stack (124); and/or
wherein an amount of air in a respective one of first filler particles (108) in the surface region (132) of the stack (124) is smaller than in a respective one of second filler particles (110) next to the at least one electrically conductive layer structure (126).

12. The component carrier (102) according to claim 10 or 11,
wherein the surface of the stack (124) is free of broken hollow filler particles; and/or
wherein the at least one electrically insulating layer structure (128) comprises a sheet (100) according to any of claims 1 to 9.

13. A manufacturing method, which comprises:
forming a first structure (104) with first filler particles (108) in a resin matrix (112);
forming a second structure (106) with second filler particles (110) in a resin matrix (112);
stacking the first structure (104) with the second structure (106) to thereby form a sheet (100); and
configuring the first filler particles (108) and the second filler particles (110) so that a hollow volume in a respective one of the second filler particles (110) is larger than in a respective one of the first filler particles (108).

14. The method according to claim 13, wherein at least one of the following features applies:
wherein the method comprises configuring the first filler particles (108) and the second filler particles (110) so that an amount of air in a respective one of the second filler particles (110) is larger than in a respective one of the first filler particles (108);
wherein the method comprises manufacturing a component carrier (102) by forming a stack (124) comprising at least one electrically conductive layer structure (126) and at least one electrically insulating layer structure (128), wherein the at least one electrically insulating layer structure (128) is formed based on the sheet (100);
wherein the method comprises forming a layer comprising the first structure (104) with the first filler particles (108) on one side of the layer and comprising the second structure (106) with the second filler particles (110) on an opposing other side of the layer.

15. Use of a component carrier (102) according to any of claims 10 to 12 for a high-frequency and/or high-speed application.
